# EUROPEAN PATENT APPLICATION

(11) **EP 4 141 871 A1**
(43) Date of publication of application: **01.03.2023**
(21) Application number: 21315139.2
(22) Date of filing: 23.08.2021
(51) Int. Cl.: G11C 11/16

(54) **MAGNETIC MEMORY DEVICE COMPRISING A CURRENT PULSE GENERATOR, AND METHOD OF OPERATING SUCH A MAGNETIC MEMORY DEVICE**

(71) Applicant: Antaios, 38240 Meylan (FR)
(72) Inventor: Brecte, Victorien, 38240 MEYLAN (FR); Louche, Julien, 38240 MEYLAN (FR); Leroy, Fabien, 38240 MEYLAN (FR); Martin, Sylvain, 38240 MEYLAN (FR); Vigier, Jérémie, 38240 MEYLAN (FR); Drouard, Marc, 38240 MEYLAN (FR)
(74) Representative: IP Trust

(57) **Abstract**

The invention concerns a current signal for writing a state in at least one SOT memory cell of a magnetic memory device. The current signal comprises a rising edge to elevate the current to a first maximum value and a trailing edge to reduce, from a trailing edge starting time, the current from the maximum value. According to the invention the current, 1 ns after the trailing edge starting time, is greater than 30% of the first maximum value. The invention also related .to a magnetic memory device and to a method for writing a first state in at least one SOT memory cell of a magnetic memory device.

## Description

### FIELD OF THE INVENTION

The present invention relates to a magneto resistive memory device.

### BACKGROUND OF THE INVENTION

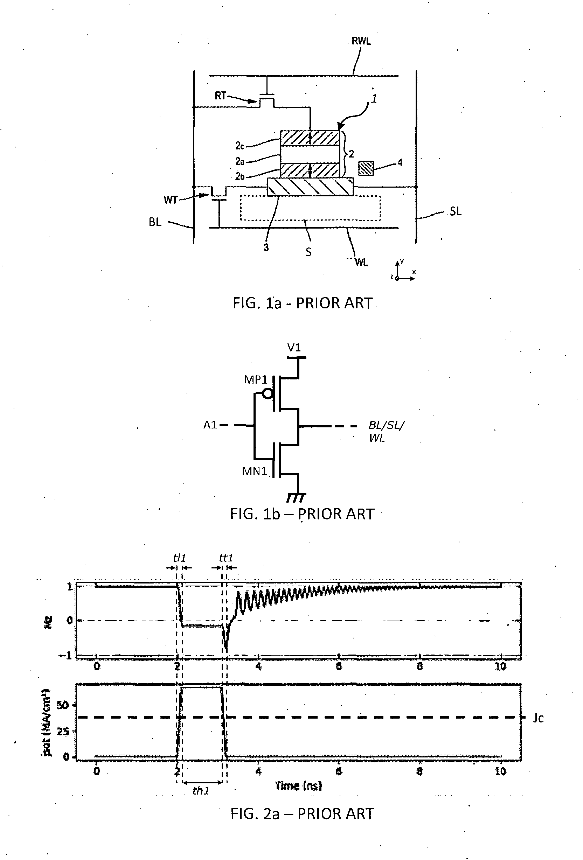

Figure 1a shows an example of a SOT memory cell of SOT magneto resistive memory device with perpendicular magnetic anisotropy. The memory cell 1 is disposed on a substrate S that defines a main plane. The memory cell 1 includes a magnetic tunnel junction structure 2 that includes a thin dielectric layer2a sandwiched between a ferromagnetic free layer 2b and a ferromagnetic reference layer 2c. The dielectric layer 2a forms a tunnel barrier layer between the reference layer 2c and the free layer 2b. The dielectric layer 2a may be formed of, or comprise, MgO, Al2O3 or other suitable dielectric materials. Its thickness can range between 0.1 nm to 3 nm, preferably between 0.5 to 2nm.

The orientation of the magnetization of the ferromagnetic reference layer 2c is fixed, perpendicular to the main plane. The magnetization orientation of the free layer 2b is switchable in the perpendicular axis into one of a parallel state or an antiparallel state with respect to the magnetization orientation of the reference layer 2c. The free layer may comprise material selected in the list constituted of Fe, Co, Ni, FeCo, CoNi, CoFeB, FeB, FePt, FePd or other suitable ferromagnetic material. The reference layer 2c may comprise materials selected in the list constituted of Fe, Co, Ni, FeCo, CoNi, CoFEB, FeB, FePt, FePd or other suitable ferromagnetic material. Finally, the dielectric layer 2a may comprise MgO, Al2O3 or other suitable dielectric materials.

The magnetic tunnel junction (MTJ) structure 2 may comprise further layers, notably additional layers disposed on top of the reference layer 2c to help fixing its magnetization and additional layers required during the manufacturing process. For instance, the magnetic tunnel junction 2 may also comprise a capping layer disposed on and in contact with the reference layer 2c. The capping layer may present a thickness comprised between 1 nm and 200 nm, and preferably between 30 nm to 100 nm. The capping layer may be formed of antiferromagnetic material, such a PtMn or IrMn, or may consist in a more complex arrangement, such as a synthetic antiferromagnet (SAF) multilayer structure. Capping material may also be formed of hard mask material used during manufacturing of the memory device.

The resistance value between the reference layer 2c and the free layer 2b is dependent on the state of the free layer magnetization orientation. When the free layer 2b and the reference layer 2c have parallel magnetizations, the magnetic tunnel junction presents a relatively lower electric resistance, whereas in the antiparallel magnetizations the magnetic tunnel junction presents a relatively higher electric resistance. The switchable relative magnetization orientation of the free layer 2b defines therefore two states of the memory cell 1, to respectively represents the "0" and "1" values of a bit of information.

The memory cell of figure 1 also comprises a SOT current layer 3 disposed in the main plane of the substrate S, and on which resides the magnetic tunnel junction 1. The SOT current layer 3 may be of rectangular shape, its width and length being sufficient to support entirely the junction 2, but other shapes are also possible. The free layer 2b of the junction 1 is electrically coupled to the SOT current layer 3, for instance the free layer 2b may be in direct contact with a first face of the SOT current layer. The SOT current layer comprises conductive heavy metal such has Ta, W, Pt, Au or other suitable metal materials. The SOT current layer 3 has a thickness that ranges between 0.5 nm and 200 nm, more particularly between 0.5 nm and 100 nm, or less than 10 nm. Preferably, the SOT current layer 3 has thickness lying in the range 0.5 nm to 5 nm.

The memory device also includes a magnetic source 4 providing a magnetic bias field extending to the magnetic tunnel junction 2. The magnetic bias field (whose amplitude is typically between 100 Oe to 1500 Oe) contributes to the deterministic' switching of the free layer magnetization when a write current is flowing in the SOT current layer. More generally speaking, the memory device may include any type of symmetry breaking mechanism, such as the magnetic source 4 presented here as an example.

In a read operation, a signal from a read word line RWL, turns on a read transistor RT to flow a read current between a bit line BL and a source line SL through the magnetic tunnel junction 2. By sensing the read current, it is possible to identify electric resistance of the magnetic tunnel junction, which is dependent on the relative orientation of the magnetization of the reference layer 2c and of the free layer 2b as mentioned above, and hence of the state store in the memory cell.

In a write operation, a signal from a write word line WL turns on a write transistor WT to flow a current pulse between the bit line BL and the source line SL in a write path including the SOT current layer of the selected memory cell. The current flowing in the SOT current layer generates spin-orbit torques that aim at changing the magnetization orientation of the free layer 2b.

It is possible to configure (i.e. write) the MTJ in a first state by passing a current pulse in one direction (for instance from the bit line BL to the source line SL) and, by reversing the current pulse direction (for instance from the source line SL to the bit line BL), it is possible to configure the MTJ in the other state. In each of these two states, the magnetization orientations of the free layer, either parallel or antiparallel to the magnetization of the reference layer 2c, is a stable orientation in the absence of a current flowing in the SOT current layer.

The injection of the current pulse in the write path is achieved by a word line driver associated with the word line WL, by a bit line driver associated with the bit line BL and by a source line driver associated with the source line SL, a conventional architecture of which is represented on figure 1b.

Such a conventional driver is made of a first main transistor MP1 (usually a PMOS transistor) and of a second main transistor MN1 (usually an NMOS transistor) connected in series between a source voltage V1 and a ground voltage. The bit line BL, source line SL or word line WL, depending on the nature of the driver, is connected to the middle point of the two transistors MP1, MN1. A control signal A1 provided by a control main block of the memory device defines the pulse to be injected into the line connected at the middle point. The first main transistor MP1, connected to the source voltage V1 pulls the line high, at the source voltage V1, at the beginning of the pulse, and the second main transistor MN1, pulls the line low, at the ground voltage, at the end of the pulse. Typically, the two main transistors are dimensioned (in particular with respect to the value of their source drain resistance), depending on the line capacitance, to pulls the line either to the source voltage V1 or to the ground, in a very short time, typically less than 1 ns.

The instantaneous magnetization direction of the free layer under the influence of the current pulse flowing in the SOT current layer evolves according to a complex and dynamic relationship, that notably depends on the materials, thicknesses of the various layers of the cell, intensity and direction of the current density, magnitude of the symmetry breaking mechanism, temperature... This dynamic relationship may present a relatively low damping constant, and the time evolution of the magnetization direction of the free layer may present complex orbits with relatively large oscillations. Consequently, the actual direction of this magnetization after the application of the write pulse, i.e. the actual state stored in the SOT memory cell, may differ from the intended state to be stored.. This phenomenon is known as the "switch back" effect.

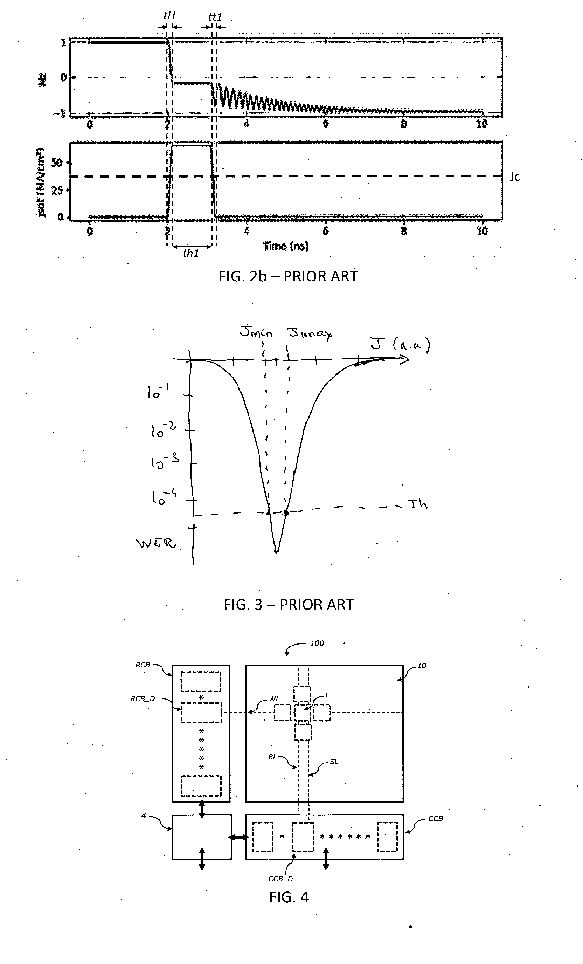

The figures 2a and 2b illustrate such switch back effect in the actual state stored in a memory cell of a memory array according to the state of the art.

Each of these figures represents the evolution over time of the normalized magnetization component Mz of the free layer along the axis perpendicular to the main plane (higher part of each figure) under the influence of an identical current pulse (lower part of each figure) applied to two slightly different memory cells. This difference arises form variation in the manufacturing parameters of the cell or variation in the operating parameters of the cell, such as temperature, external magnetic field, etc. The normalized magnetization component Mz evolves in the range [-1, 1], the two extremity of this range representing antiparallel orientations of a direction perpendicular to the main plane. The write pulse is a conventional current write pulse (whose amplitude jsot on figures 2a, 2b is indicated as a current density in the SOT layer 3), presenting relatively short leading edge t11 and trailing edge tt1 durations (of the order of 100 ps), and a relatively long hold time duration th1 (of the order of the ns or more). The short trailing edge of the current pulse induces oscillations in the magnetization direction that stabilizes into a final state. In one case, represented in figure 2a, the final and stable orientation of free layer magnetization rests with a "1" value identical to its initial orientation, and in the other case, represented on the figure 2b, the final and stable orientation of the free layer magnetization rests with a "-1" value opposed to its initial orientation.

Writing state sensitivity with respect to the actual manufacturing and operational parameters of the cell (the "switch back" effect) is intrinsic to the dynamics of the magnetization in the free layer of a SOT memory cell. This sensitivity provokes a rather important write error rate in known SOT memory cell with perpendicular magnetic anisotropy. "Write error rate" corresponds to the ratio of the number of erroneous states stored over the total number of states stored in a memory cell. And this phenomenon is exacerbated at high current density, i.e. when the maximum absolute value of the write pulse is increased, as this is illustrated in figure 3 that represents the evolution of the write error rate with the maximum value of the current write pulse of a memory device according to the state of the art.

In this representation, the x-axis represents the maximum value of the current pulse (in terms of current density).. The y-axis represents the write error rate. Generally speaking, it is desirable that the write error rate of a functional memory array to be below a given threshold Th, for instance below 10^-6, considering that a memory array includes error detection and correction mechanism that may compensate the residual error rate, i.e. below this threshold Th. The figure 3 shows that a minimum value of the current Jmin must be exceeded to reliably store a given state in the memory cell, to exceed the write error rate threshold Th. Similarly, the figure 3 shows that, with the maximum value of the current pulse increasing, the write error rate also increases. Therefore, in the SOT memory cell of the state of the art, the maximum value of the current pulse must be controlled very precisely to lie in a very narrow range [Jmin, Jmax] to obtain a satisfactory write error rate. This narrow range may even not exist at all. Such control may be difficult to implement, and therefore the SOT memory device may present an excessive write error rate that cannot be compensated by error detecting and correcting circuits. Also, experience has shown that the write error rate and indeterministic switching is also largely impacted by the presence of an external magnetic field.

To address the problem of indeterministic switching the document US10115443 proposes to adjust the duration of a writing pulse. However, such duration may be very difficult to control in a large capacity magneto resistive memory device, notably when the pulse duration is below one nanosecond, due to manufacturing differences in the device parameters, from one memory cell to the other.

### OBJECT OF THE INVENTION

The present invention aims at providing a SOT memory device that does not presents this limitation, and that is more robust to manufacturing and operational variations, within one cell or from cell to cell. More specifically, the invention aims at providing a SOT memory device whose write error rate is less sensible to the absolute maximum value of the current pulse.

### SUMMARY OF THE INVENTION

To this effect, the invention relates to a magnetic memory device comprising:
- at least one source line provided with a source line driver and at least one bit line provided with a bit line driver ;
- at least one SOT memory cell comprising:
   ∘ a SOT current layer, defining a main plane, electrically disposed between the source line (SL) and the bit line to define a write path comprising the bit line, the SOT current layer and the source line, and
   ∘ a free layer disposed on and coupled to the SOT current layer, a magnetization direction of the free layer being perpendicular to the main plane, and the magnetization orientation of the free layer defining a state of the memory cell ;
- at least one word line provided with a word line.driver, to control a write transistor disposed in the write path.

The bit line driver, the source line driver and/or the word line driver are configured to write a first state in the SOT memory cell by injecting a first current pulse along a first direction of the write path, the first current pulse comprising a rising edge to elevate the current to a first maximum value and a trailing edge to reduce, from a trailing edge starting time, the current from the first maximum value.
According to the invention, the magnetic memory device is configured such that, 1 ns after the trailing edge starting time, the current of the first current pulse is greater than 30% of the first maximum value.

The applicant has observed that the switched back effect that is at the origin of the rather important write error rate presented in the introduction could be prevented by controlling the trailing edge of the current pulse injected in the write path, such that this trailing edge is relatively long.

According to further non limitative features of the invention, either taken alone or in any technically feasible combination:
- the current of the first current pulse, 1 ns after the trailing edge starting time, is greater than 60% of the first maximum value, preferentially greater than 80% of the first maximum value;
- the magnetic memory device is also configured to write a second state in the SOT memory cell by injecting the first current pulse along a second direction into the write path, the second direction being opposite to the first direction;
- the magnetic memory device is also configured to write a second state in the SOT memory cell by injecting a second current pulse along the first direction of the write path, the second current pulse comprising a rising edge to elevate the current to a second maximum value and a trailing edge to reduce, from the trailing edge starting time, the current from the second maximum value, such that, 1 ns after trailing edge starting time of the second current pulse, the current is less than 30% of the second maximum value;
- the second maximum value is equal to the first maximum value;
- the second maximum value is superior or equal to a critical current value for which the first state is stored in the SOT memory cell with a write error rate equal to 1;
- the memory cell further comprises a thin dielectric layer sandwiched between the free layer and a ferromagnetic reference layer to form a magnetic tunnel junction structure;
- the magnetic memory device further comprises additional layers disposed on top of the ferromagnetic reference layer;
- the trailing edge of the first current pulse presents a substantially constant slope;
- the trailing edge of the first current pulse comprises a first portion and a second portion following the first portion, the average slope of the first portion being smaller than the average slope of the second portion;
- the second portion decreases strictly monotonically;
- the trailing edge comprises a plateau;
- the word line driver comprises two main transistors connected in series in between a first word line source voltage a ground voltage, the word line being connected to a middle point of the two main transistors, and wherein the word line driver further comprises a capacitance disposed between the word line and a controllable source of boost voltage;
the first maximum current value of the first current write pulse is maintained during a hold time duration comprised between 0 ns and 100 ns, and preferably between 0 ns and 10 ns.
According to a second aspect, the invention relates to a method for writing a first state in at least one SOT memory cell of a magnetic memory device, the magnetic memory device comprising at least one source line provided with a source line driver and at least one bit line provided with a bit line driver, the SOT memory cell (1) comprising:
∘ a SOT current layer, defining a main plane, electrically disposed between the source line and the bit line to define a write path comprising the bit line, the SOT current layer and the source line, and
∘ a free layer disposed on and coupled to the SOT current layer, a magnetization direction of the free layer being perpendicular to the main plane, and the magnetization orientation of the free layer defining a state of the memory cell ;

The magnetic memory device further comprises at least one word line provided with a word line driver, to control a write transistor disposed in the write path.

The method comprises injecting a first current pulse along a first direction of the write path, the first current pulse comprising a rising edge to elevate the current to a first maximum value and a trailing edge to reduce, from a trailing edge starting time, the current from the first maximum value.

According to the invention, the first current pulse is prepared such that, 1 ns after the trailing edge starting time, the current of the first current pulse is greater than 30% of the first maximum value.

According to further non limitative features of this aspect of the invention :
- injecting a first current pulse along a first direction of the write path comprises an opening step of opening the write transistor by applying a controlled voltage on a gate of the write transistor to control the trailing edge of the first current pulse;
- injecting a first current pulse along a first direction of the write path comprises a discharging step of discharging the bit line and/or the source line, the discharging step being conducted to control the trailing edge of the first current pulse;

Finally, and according to a further aspect, the invention relates to a current signal for writing a state in at least one SOT memory cell of a magnetic memory device, the current signal comprising a rising edge to elevate the current to a first maximum value and a trailing edge to reduce, from a trailing edge starting time, the current signal from the first maximum value.

A current signal according to the invention is such that, 1 ns after the trailing edge starting time, the current is greater than 30% of the first maximum value.

### FIGURES

Many other features and advantages of the present invention will become apparent from reading the following detailed description, when considered in conjunction with the accompanying drawings, in which:
- Figure 1a represents a SOT memory cell of known SOT magneto resistive memory device with perpendicular magnetic anisotropy;
- Figure 1b represents a conventional driver for a bit line, a source line or a word line of a known magneto resistive memory device;
- Figures 2a and 2b illustrate the uncertainty in the actual state stored in a SOT memory cell of a known SOT magneto resistive memory device;
- Figure 3 represents the evolution of the bit error rate of a SOT memory cell with the maximum absolute value of a current write pulse in a known SOT magneto resistive memory device;
- Figure 4 represents magnetic memory device according to the invention;
- Figures 5a to 5d illustrates the influence of the trailing edge duration on the write error rate of a memory cell;
- Figure 6a to 6c represents different write current pulse according to various embodiments;
- Figure 7a represents a write pulse with a trailing edge presenting a substantially constant slope, and figures 7b to 7f present various driver circuit to produce such a shape;
- Figure 8a represents a write pulse with a trailing edge presenting two portions, and figures 8b to 8f present various driver circuit to produce such a shape;
- Figure 9a represents a write pulse with a plateau, and figures 9b to 9f present various driver circuit to produce such a shape.

### DETAILED DESCRIPTION OF SPECIFIC EMBODIMENTS OF THE INVENTION

For simplification of the following description, the same references are used for identical elements or elements achieving the same function in the different embodiments of the invention that will be described.

To keep the representations simple, only the elements relevant to the description of the present invention have been included in the figures. A memory device taking profit of the features- if the present disclosure may comprise further elements not included into the figures. In particular, the memory device includes the conventional read circuits that are not described in details in this disclosure.

### General description of the magneto resistive memory device

Figure 4 represents a magneto resistive SOT memory device 100 according to the invention.

In this memory device 100, a large number of memory cells 1, similar to the one represented on figure 1 are provided in rows and columns to form a bit cell, array 10. Bit lines BL and sources lines SL are arranged along respective columns of memory cells. Read word lines (not represented) and write word lines WL are arranged along respective rows of the memory cells array 10. A row of memory cells (or a plurality of memory cells in the row) may be collectively written, by activating the corresponding word line WL by row drivers RCB_D of a row control block RCB, and by activating the bit lines BL and sources lines SL by respective column drivers CCB_D of a column control block CCB such that the writing currents flows in the respective bit lines BL - source lines SL along a direction allowing to set the desired state of each selected memory cell 1. Usually, all the column drivers CCB_D are operated simultaneously to write respective data in at least some of the memory cells of a selected row, but this conventional mode of operation is not necessary. A main control block 4 is coordinating the read (not described in this disclosure) and write operations. More particularly, the main control block 4 generates the control signals to the drivers of the column drivers CCB_D and to the row drivers RCB_D to achieve the sequence of steps necessary to perform the intended write operations. The control block 4 may implement a finite state machine, or more generally be configured, to generate the appropriate control signals, as this will be described in more details in a subsequent part of this disclosure. Input/output data may then be stored/retrieved from the magnetic memory device.

A magnetic memory device 100 according to the invention therefore comprises at least one source line SL provided with a source line driver and at least one bit line BL provided with a bit line driver. The source line driver and the bit line driver are elements of the column driver of the column control block CCB of figure 4.

The magnetic memory device 100 also comprises at least one SOT memory cell 1 formed of a SOT current layer, defining a main plane, electrically disposed between the source line SL and the bit line BL to define a write path comprising the bit line BL, the SOT current layer and the source line SL. The SOT memory cell 1 also comprises a magnetic free layer disposed on and coupled to the SOT current layer, a magnetization direction M of the free layer 2 being perpendicular to the main plane, and the magnetization orientation of the magnetic free layer defining a state of the memory cell 1.

The characteristics of the memory cell 1 have been recalled in the introduction of this application in reference to figure 1, and will not be reproduced here for the sake of brevity, but those characteristics fully apply to the memory cell 1 of a memory array according the invention.

The magnetic memory device 100 also comprise at least one word line WL provided with a row driver RCB_D of the row control block RCB represented on figure 4, to control a word line transistor WLT disposed in the write path. In some embodiments, that will be more fully described in a subsequent portion of this disclosure, a memory cell may be provided with a plurality of write transistors WT all disposed in a single write path. Each write transistor WT may then be controlled by a dedicated word line WL, and in this case a plurality of word'lines WL and word line drivers RCB_D may .be associated with a single SOT memory cell 1.

In the present disclosure, by convention, the main control block 4, the bit line driver , the source line driver and/or the word line driver RCB_D are configured to write a first state in the SOT memory cell 1 by injecting a first current pulse along a first direction of the write path, the first direction being from the bit line BL to the source line SL. So, by convention, the first state is written in the SOT memory cell by injecting a first current pulse into the bit line, the first current pulse then propagating along the write path into the SOT layer and the source line SL.

For the sake of precision, and as shown on a figures 2a, 2b, a current pulse injected into the bit line BL comprises a rising edge, to elevate the current from 0 to a maximum value, and a trailing edge to reduce the current from the maximum value to 0. The hold time duration corresponds to the period of time during which the maximum value is held relatively constant, typically form 1ns or less to 10ns or more.

### General observations and description of the write current pulse

The applicant has observed that the switched back effect that is at the origin of the rather important write-error rate presented in the introduction could be prevented by controlling the trailing edge of the current pulse injected in the write path. Generally speaking, the applicant has observed that a longer trailing edge tends to reduce the switch back effect compared to a shorter trailing edge. Said differently, by controlling the trailing edge duration to be relatively long, it is possible to more reliably store a given state in the memory cell, with much less sensitivity to the maximum value of the current pulse. It has been also shown also that the sensitivity to an external magnetic field can be reduced with such relatively longer trailing edge.

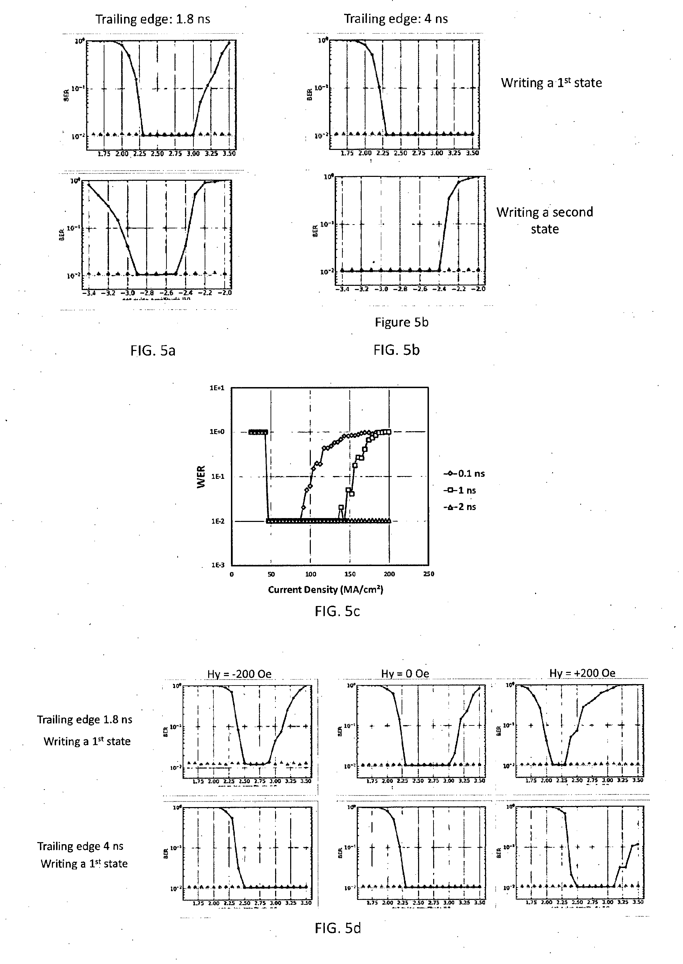

Figure 5c is a first illustration of this observation, obtained by simulation. This figure represents the write error rate (WER) as a function of the pulse maximum current for a given memory cell architecture (express in term of current density in the SOT layer 3). The write error rates have been obtained for three current pulses differing by the duration of their (linear) trailing edge: one relatively short trailing edge (0.1 ns), one intermediate trailing edge (1ns) and one relatively long trailing edge (2ns). It can be observed on the graph of figure 5c, that a relatively long trailing edge provides a better write error rate performance, i.e. a lower write error rate over a wider range of the pulse maximum currents.

To better illustrate this observation, figures 5a, 5b present the write error rates actually measured, in a given memory array and memory cell architecture, according to the maximum value of the write pulse (in arbitrary units), respectively for write current pulses presenting two different shapes.

In both cases, the write current pulse had a hold time duration of 10 ns. The rising edge of the current pulse was conventional, of the order of 1ns. The data that lead to the write error rate performance represented on figure 5a, were collected using a current pulse with a comparatively short (linear) trailing edge, of 1.8 ns. The data that lead to the write error rate performance represented on figure 5b, were collected using a current pulse with a comparatively long (linear) trailing edge, of 4 ns. Each write error rate values represented on these figures results from 100 measurements, such that the best obtainable write error rate is 10^-2, represented by the triangular marks on these figures.

For each case represented on figures 5a and 5b, the current pulse has been injected along a first direction of the write path (top part of these figures) to write a first state, and injected along a second direction of the write path, opposite to the first direction, to write a second state opposite of the first state (bottom part of these figures).

It can be observed by comparing the figures 5a and 5b that, by controlling the trailing edge to be longer, it is possible to obtain minimum write error rate for a large range of current pulse maximum values, as long as this maximum value is larger, in absolute terms, than a threshold value.

Finally, Figure 5d illustrates the improvement made to write error rate, while storing a first state in a SOT memory cell for longer trailing edge, in the presence of an external magnetic field. The top graphs on figure 5d shows the evolution of the write error rate with the maximum value of the current pulse (in arbitrary units), for a trialing edge of 1.8ns, and in presence of an external magnetic field of respectively -200 Oe, 0 Oe, and + 200 Oe. This external magnetic field is oriented in the z direction with respect to the cell, in the coordinate system represented on figure 1, perpendicular to the current circulating in the SOT layer 3. It is visible that the presence of a non-zero external magnetic field, either -200 Oe or +200 Oe on the graphs, degrades the write error rate .profile of the cell, since it narrows the range of maximum current values that provides the best write error rate.

The bottom graphs of figure 5d show the same evolution of the write error rates but, in this case, for a relatively longer trailing edge of the current pulse of 4ns. For each of the graphs, the range of maximum current values that provides the best write error rate is widened when compared to the corresponding graph for shorter trailing edge. Also, it can be seen that for such long trailing edge, the write error rate is less sensible to the presence of an external magnetic field.

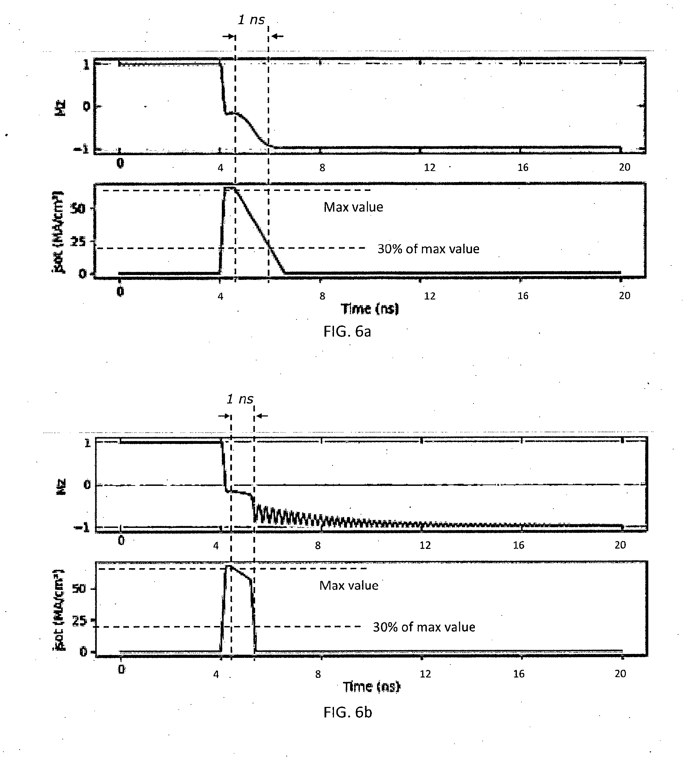

To take profit of the observation reported above it is proposed to control the write current pulse such that, 1 ns after the trailing edge starting time, the current of the current pulse is greater than 30% of the maximum value of the pulse. The trailing edge starting time is the time at which the current pulse starts to decrease from its maximum value. Such a current pulse is represented in figure 6a.

With such a pulse shape, a practicable write error rate is obtainable for a sufficiently large range of maximum current, for most if not all practicable SOT memory cell and memory cell array. In particular, it has been shown that improvement of the write error rate is obtained by controlling the shape of the pulse in the initial portion of the trailing edge, in the initial portion of time that follows the trailing edge starting time.

So, according the invention, the memory device 100 is operated for writing a first state in at least one SOT memory cell 1 by injecting a first current pulse along a first direction of the write path, the first current pulse comprising a rising edge to elevate the current to a first maximum value and a trailing edge to reduce, from a trailing edge starting time, the current from the first maximum value. The first current pulse is prepared such that, 1 ns after the trailing edge starting time, the current of the first current pulse is greater than 30% of the first maximum value.

Advantageously, the first current pulse is controlled such that the current of the first current pulse, 1 ns after the trailing edge starting time, is greater than 60% of the first maximum value, preferentially greater than 80% of the first maximum value of the pulse. Indeed, by increasing the duration of the write current pulse trailing edge, the performance of the cell and of the cell array is improved, as reported above. It has also been observed that the SOT memory cell 1 is more robust to the switch back effect when the average slope of the trailing edge is decreased in the first ns that follows the trailing edge starting time.

This gives a lot of flexibility to define the actual shape of first pulse trailing edge, while still preserving the condition that, 1 ns after the trailing edge starting time, the current of the first current pulse is greater than 30% of the first maximum value (and advantageously greater than 60% or 80%). The trailing edge of the first current pulse may presents a substantially constant slope, i.e. within 10% of a constant slope, as this is represented on figure 6a.

The trailing edge of the first current pulse may comprises a first portion and a second portion following the first portion, the average slope of the first portion being smaller than the average slope of the second portion. An exemplary pulse conforming to this configuration is represented on figure 6b. By having a second portion with increased slope, it allows to reduce the overall duration of the pulse while respecting the condition that, 1 ns after the trailing edge starting time, the current of the first current pulse is greater than 30% of the first maximum value (and advantageously greater than 60% or 80%).

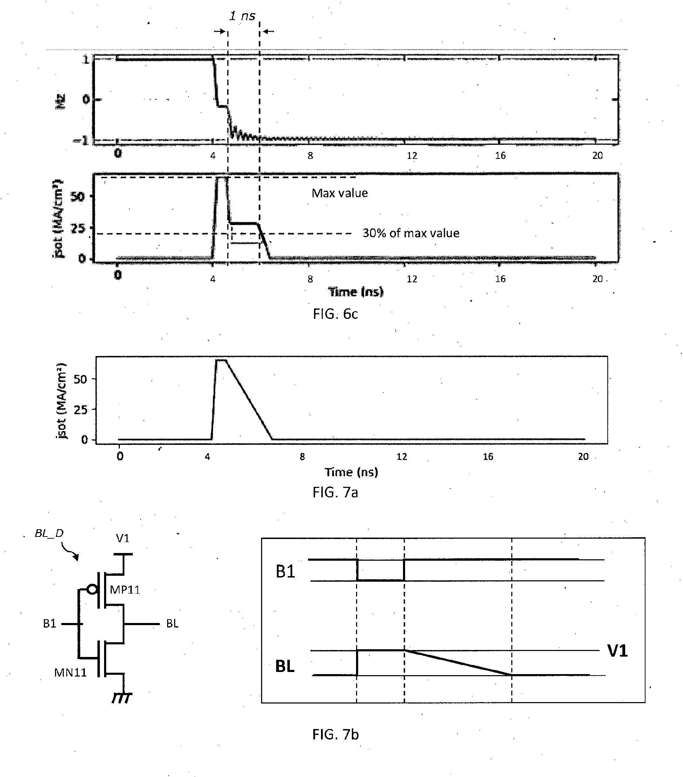

The first current pulse may also comprise a plateau. An exemplary pulse conforming to this configuration is represented on figure 6c. The height of the plateau. The height (if selected sufficiently close to the first maximum value) and duration of the plateau may help in respecting the condition that, 1 ns after the trailing edge starting time, the current of the first current pulse is greater than 30% of the first maximum value (and advantageously greater than 60% or 80%).

As this can be seen on the top part of figures 6a, 6b, 6c, the relatively long trailing edge of the write pulse the SOT memory cell 1 is more robust to the switch back effect.

Typically, the first maximum current value of the first current write pulse is maintained during a hold time duration comprised between 0 ns and 100 ns, and preferably between 0 ns and 10 ns.

To actually shape the first current pulse and to actually inject such a current pulse into the write path, the memory device 100 comprises bit line drivers, source line drivers and/or word line drivers specifically configured and operated by the main control block 4, as this will be exposed in greater details in a subsequent part of this disclosure.

### Bipolar and unipolar architecture

The principles guiding the shaping of the write current pulse, and in particular the shape of the trailing edge of the current pulse, that have just been exposed can be exploited according to two different embodiments.

According to a first embodiment, called "bipolar", the same principle of providing long trailing edge is used for storing a first or a second state (opposite to the first one) in the memory cell, by injecting a first current pulse in a first direction of the write path or in a second direction of the write path, opposite to the first one. More specifically, the bit line driver, the source line driver and/or the word line driver are configured and operated to write a first state in the SOT memory cell 1 by injecting the first current pulse along a first direction of the write path. In the bipolar embodiment, the bit line driver, the source line driver and the word line driver are also configured and operated to write a second state in the SOT memory cell 1 by injecting the first current pulse along a second direction into the write path, the second direction being opposite to the first direction, i.e from the source line SL to the bit line BL under the convention retained in the present disclosure.

To allow this embodiment, the bit line driver and source line driver of each column drivers are identical or at least can be operated to exhibit the same behavior, such that a write pulse with the desired shape could be injected indifferently in the bit line BL or in the source line SL. Therefore, the implementation of bit line drivers presented in a next section of the invention are also used as source line drivers.

The principle of the invention could also be implemented according to a second embodiment, called "unipolar". In this second embodiment, the second state of the memory cell is stored by injecting a second current pulse in the write path, in the same first direction used for storing the first state. However, the second current pulse is configured to present a rather short trailing edge and present a second maximum value such that the first cannot reliably be written into the cell (i.e. the write error rate of the first state is important, equal or close to 1). Also, the second current pulse is configured such that the write error rate of the second state is low, ie close or equal to 1. Consequently, the second state opposite to the first state is reliably stored in the memory cell when the second current pulse is injected in the write path, even if this second current pulse is injected along the same direction as the one used for storing the first state.

Preferably, to make sure that the desired second state has been effectively stored in the SOT memory cell, the second maximum value is superior or equal to a critical current value for which the first state is stored in the SOT memory cell 1 with a bit error rate equal to 1.

So, in a memory array according to this unipolar embodiment, the bit line driver, the source line driver and the word line driver are configured to write a second state in the SOT memory cell 1 by injecting a second current pulse along the first direction of the write path. The second current pulse comprises a rising edge to elevate the current to a second maximum value and a trailing edge to reduce, from the trailing edge starting time, the current from the second maximum value, such that, 1 ns after trailing edge starting time of the second current pulse, the current is less than 30% of the second maximum value.

In this unipolar embodiment, since the functioning is not symmetrical, the bit line driver and source line driver of each column drivers CCB_D may be different from each other.

For instance, the bit line driver may comprise a first bit line driver configured to inject the first current pulse with a long trailing edge, and also comprise a second bit line driver to inject the second current pulse presenting the short trailing edge. The second bit line driver may correspond to a conventional driver, as the one represented on figure 1b. The source line driver may also be a conventional driver. In this unipolar embodiment, the central control block 4 activates either the first or the second bit line driver according to which state, the first state or the second state, is to be stored in the memory cell 1. In a further example, a single bit line driver may be configured and selectively controlled by the central control block 4 to either inject the first current pulse with a long trailing edge or to inject the second current pulse presenting a short trailing edge.

In an alternative configuration, the bit line drivers and source line drivers may all be conventional, but the memory device is provided by two distinct word line drivers, selectively activated by the central control block 4 according to which state is to be stored in the memory cell. The first word line driver operates the write transistor WT to shape the first current pulse with a long trailing edge, and the second word line driver, that may be a conventional word line driver as the one presented on figure 1b, operates the write transistor WT to shape the second current pulse with a short trailing edge. In a further example, a single world line driver may be may be configured and selectively controlled by the central control block 4 to either shape the first current pulse with a long trailing edge or to shape the second current pulse presenting a short trailing edge.

To simplify the construction of the different drivers that may be required in the unipolar embodiment, the first maximum value of the first current pulse that is used to store a first state, and the second maximum value of the second current pulse that is used to store a second state could be selected to be equal to each other. In this case, the first current pulse and second current pulse may only differ by the duration of their trailing edges, the trailing edge of the second current pulse being shorter than the trailing edge of the first current pulse.

### Mode of operation of the bit line, source line and word line drivers

Generally speaking the various bit line, source line and word line drivers of the memory device 100 may operate according to two modes of operation, under the supervision of the main control block 4. The two modes of operation are compatible with the bipolar or with the unipolar architecture described above.

According to a first mode of operation, the injection of the first current pulse along a first direction of the write path, to store the first state in the SOT memory cell 1, comprises a precharging step of pre-charging the bit line BL to a source voltage and the source line SL to the ground voltage using the respective bit line driver and source line driver. In a closing step, the write transistor WT is closed by activating the word line driver. Once closed, the write path is formed, and the first current pulse flows in the SOT current layer. Then, in an opening step, the write transistor is opened by de-activating the word line driver. Once opened, the write path is not formed any more; and the first current pulse is interrupted. During this opening step of this first mode of operation, the word line driver delivers a precisely controlled voltage on the gate of the write transistor to progressively open the write path and to control the trailing edge of the first current pulse to be long, i.e 1 ns after the trailing edge starting time, the current of the first current pulse is greater than 30% of the first maximum value (and advantageously greater than 60% or 80%). This first mode of operation may also comprise a discharging step of discharging the bit line BL.

In this first mode of operation, the bit line drivers and source line drivers may be conventional drivers, as represented on figure 1b. The word line driver is especially configured to precisely control the opening of the write path, such that the trailing edge of the first current pulse is long.

When this first mode of operation applies to a bipolar architecture, the same functioning applies to form the second current pulse that is injected into the source line SL to propagate along the second direction of the write path.

When this first mode of operation applies to a unipolar architecture, it only concerns the injection of the first current pulse, as the second current pulse flowing into the same first direction of the write path is conventional, and uses conventional drivers.

Alternatively, and according to a second mode of operation, the injection of the first current pulse along a first direction of the write path, to store the first state in the SOT memory cell 1, comprises a closing step of closing the write transistor WT, and an opening step of opening the write transistor, the closing and opening step being activated by a conventional word line driver WL_D. The second mode of operation also comprises a charging step and a discharging step of, respectively, charging and discharging the bit line BL by activating the bit line driver while the source line is maintained to ground value or any other suitable reference voltage. Consequently, a current pulse flows in the write path. The discharging step is performed before the opening step of opening the write transistor and the bit line driver is configured to precisely control the discharging of the bit line to precisely shape the trailing edge of the first write pulse to be long, i.e 1 ns after the trailing edge starting time, the current of the first current pulse is greater than 30% of the first maximum value (and advantageously greater than 60% or 80%) .

When this second mode of operation applies to a bipolar architecture, the same functioning applies to shape the second current pulse that is injected into the source line SL to propagate along the second direction of the write path. Consequently, the source line driver is configured to precisely control the discharging of the source line to precisely shape the trailing edge of the second write pulse to be long, i.e 1 ns after the trailing edge starting time, the current of the first current pulse is greater than 30% of the first maximum value (and advantageously greater than 60% or 80%).

When this second mode of operation applies to a unipolar architecture, it only concerns the injection of the first current pulse, as the second current pulse flowing into the same first direction of the write path is conventional, and uses conventional drivers.

Naturally, a magnetic memory device according to the invention may combine the two modes of operations, and generally speaking the injection of a current pulse according to the invention may be obtained by configuring and operating the word line driver RCB D and/or the bit line driver BL_D and/or the source line driver SL_D to shape the write pulse as desired.

The remaining part of this disclosure presents in details possible bit line, source line and word line driver circuit that may be used and combined in the various architecture (bipolar - unipolar) and mode of operation that have been described. As already mentioned, the source line drivers may also be configured identically to the bit line drivers in the bipolar architecture of the invention, to shape the second current pulse. For the sake of brevity, the description of the source line drivers has therefore been omitted.

### Example 1

In this first example, the trailing edge of the first current pulse presents a substantially constant slope, as shown on figure 7a. The various circuit that are described in this section allows to shape the first current pulse accordingly.

Figure 7b represents a bit line driver BL_D that is configured to produce the first pulse of figure 7a in a memory device operating according to the second mode of operation, where the bit line driver is operated after the word line driver closes the write transistor WT to create the write path. The word line driver may then be of conventional nature.

Such a bit line driver BL_D comprises a first and a second main transistors MP11, MN11 connected in series in between a source voltage V1 and a ground voltage. The bit line BL is connected to a middle point of the two main transistors MP11, MN11. A bit line driver control signal B1 provided by the main control block 4 is complementary applied to the gates of the two main transistor MP11, MN11, to either connect the bit line BL to the source voltage V1 or to the ground, and therefore shape the first current pulse. The second main transistor MN11 connected to the ground voltage is a resistive transistor. It has been dimensioned to slowly pull down the bit line, given the capacitance of the write path. More particularly, the drain source resistance of this second, main transistor MN11 is such that, when combined with the capacitance of the write path, the trailing edge of the first current pulse decreases slowly, i.e. such that, 1 ns after the trailing edge starting time, the current of the first current pulse is greater than 30% of the first maximum value.

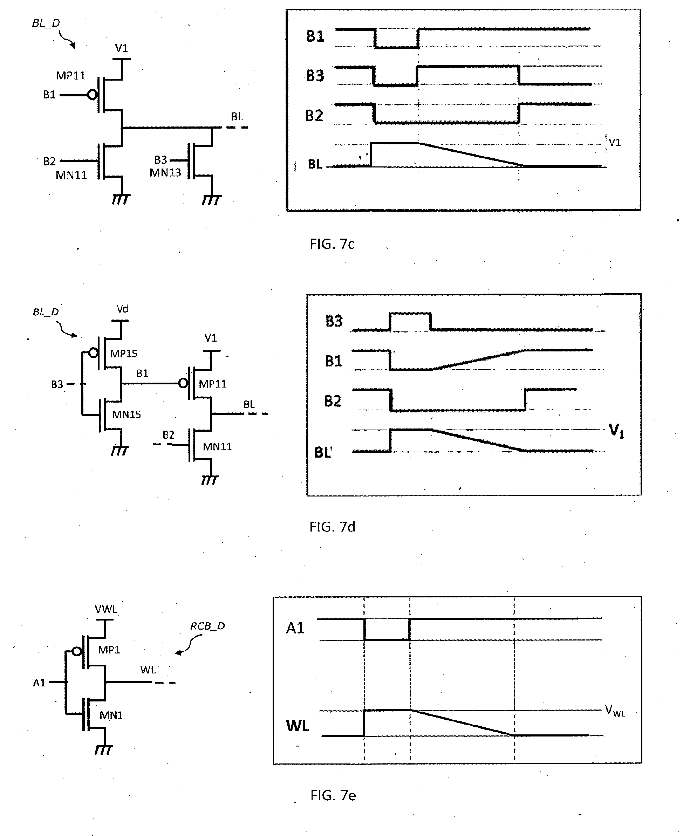

Figure 7c represents an alternative circuit to the one presented on figure 7b. The bit line driver BL_D of figure 7c is also configured to produce the first current pulse of figure 7a with a trailing edge presenting a constant decreasing slope.

The bit line driver BL_D comprises a first and a second main transistors MP11,MN11 connected in series in between a source voltage V1 and a ground voltage. In this alternative circuit the main transistors MP11,MN11 may be conventional. The bit line BL is connected to a middle point of the two transistors MP11, MN11. In the example represented on figure 6c, two bit line driver control signals B1,B2 provided by the main control block 4 of the memory array 100 are respectively connected to the gate of the first and a second main transistors MP11, MN11, to individually control the connection of the bit line BL to the source voltage V1 (to charge the bit line) or to the ground voltage (to discharge the bit line). The bit line driver further comprises at least one additional transistor MN13 connected to the bit line and to the ground, in parallel to the second main transistor MN11. A third bit line driver control signal B3 provided by the main control block 4 is connected to the gate of the additional transistor MN13. The additional transistor MN13 is a "resistive transistor. It has been dimensioned, when combine with the write path capacitance, to slowly pull down the bit line to ground. More particularly, the drain source resistance of this additional transistor MN13 is such that the trailing edge of the first current pulse decreases slowly, i.e. such that, 1 ns after the trailing edge starting time, the current of the first current pulse is greater than 30% of the first maximum value. The main control block 4 generates the first, second and third bit line driver control signal B1, B2, and B3 such that first the bit line BL is pulled up to the source voltage V1, then slowly pull down to shape the trailing edge of the first current pulse through the additional transistor and then, once pull down at ground, the second main transistor MN11 connected to the ground is activated to secure the potential of the bit line to ground.

Figure 7d represents a further alternative of the circuit of figure 7b and 7c. The bit line driver BL_D of figure 7d is configured to produce the first pulse of figure 7a with a trailing edge presenting a constant decreasing slope.

The bit line driver of this figure 7d comprises two main transistors MP11, MN11 connected in series in between a source voltage V1 and the ground voltage. In this alternative circuit the main transistors MP11,MN11 may be conventional. The bit line BL is connected to a middle point of the two transistors MP11, MN11. The bit line driver BL_D further comprises a driving circuit MP15, MN15 connected to the gate of the main transistor MP11 connected to the source voltage. The driving circuit operates this transistor MP11 in linear mode. The driving circuit receives a driving circuit control signal B3 from the main control block. The driving circuit is made of two transistors MN15, MP15 in series between a ground voltage and a driving voltage Vd. The transistor MP15 of the driving circuit connected to the source voltage is a resistive transistor. More particularly, the drain-source resistance of the transistor MP15 connected to the driving voltage Vd is selected such that the bit line driver control signals B1 (that is provided on the gate of the main transistor MP11 connected to the source) evolve slowly. This driver control signal B1 evolves such that the main transistor connected to the source voltage V1 slowly decreases the voltage applied on the bit line BL. In this way, the trailing edge of the current pulse injected on the bit line BL decreases slowly, i.e. such that, 1 ns after the trailing edge starting time, the current of the first current pulse is greater than 30% of the first maximum value. Another bit line driver control signals B2 provided by the main control block 4 is applied to the main transistor MN11 connected to the ground, to pull down the voltage on the bit line once the other main transistor MP11 is fully closed and to secure the ground voltage on the bit line.

Figure 7e represents a word line driver RCB_D that is configured to produce the first pulse of figure 7a in a memory device operating according to the first mode of operation where the bit line is pre-charged and the word line driver RCB_D delivers a precisely controlled voltage on the gate of the write transistor WT to progressively open the write path, to control the trailing edge of the first current pulse to be long. The bit and source line drivers may then be of conventional nature.

The circuit of figure 7e is similar to the circuit of figure 7b. A word line driver control signal A1 is applied to the gate of a first and a second main transistors MP1, MN1 connected in series in between a world line source voltage VWL and a ground voltage. The second main transistor MN1 connected to the ground voltage is a "resistive transistor. It has been dimensioned to slowly pull down the word line, given the capacitance of the word line. More particularly, the drain source resistance of this second main transistor MN1 is such that, when combined with the capacitance of the write line WL, the write transistor WT opens slowly. In consequence, the write transistor WT is shaping the first current pulse trailing edge, such that, 1 ns after the trailing edge starting time, the current of the first current pulse is greater than 30% of the first maximum value.

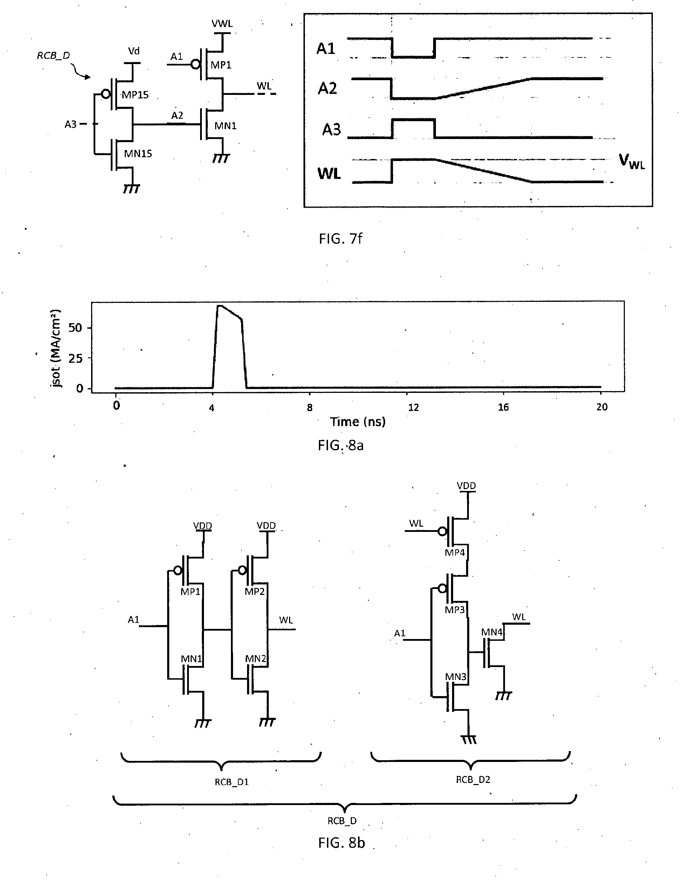

Figure 7f represents an alternative circuit of the word line driver RCB_D of figure 7e. The circuit of figure 7f is also configured to produce the first pulse of figure 7a with a trailing edge presenting a constant decreasing slope.

Similarly to the circuit of figure 7d, a driving circuit MP15, MN15 is providing a control signal A2 to the gate of a main transistor MN1 connected to the ground, of a conventional driver circuit made of two main transistors MP1, MN1 connected in series in between a word line source voltage VWL and the ground voltage. The word line WL is connected to a middle point of the two main transistors MP11, MN11.

The driving circuit MP15, MN15 operates the main transistor MN1 in linear mode. The driving circuit receives a driving circuit control signal A3 from the main control block 4. The driving circuit is made of two transistors MN15, MP15 in series between a ground voltage and a driving voltage Vd. The transistor MP15 of the driving circuit connected to the driving voltage Vd is a "resistive transistor. More particularly, the drain-source resistance of the transistor MP15 connected to the driving voltage is selected such that the word line driver control signals A2 (that is provided on the gate of the main transistor MN1 connected to the ground) evolve slowly. This driver control signal A2 evolves such that the main transistor MN1 connected to the ground progressively pulls down the write line WL to the ground, once the main transistor MP1 connected to the source voltage has been deactivated by the main control block 4. In consequence, just like in the previous example, the write transistor WT is shaping the first current pulse trailing edge, such that, 1 ns after the trailing edge starting time, the current of the first current pulse is greater than 30% of the first maximum value.

### Example 2

In this example 2, the trailing edge of the first current pulse comprises a first portion and a second portion following the first portion, the average slope of the first portion being smaller than the average slope of the second portion, as shown on figure 8a. In this figure the second portion of the first current pulse trailing edge decreases strictly monotonically, but this is not a required feature.

Figure 8b represents a word line driver RCB_D that is configured to produce the first pulse of figure 8a in a memory device operating according to the first mode of operation where the bit line is pre-charged and the word line driver RCB_D delivers a precisely controlled voltage on the gate of the write transistor WT to progressively open the write path and to control the trailing edge of the first current pulse to be long. The bit line drivers and source line drivers of the memory array may be conventional in this first mode of operation.

The word line driver RCB_D of figure 8b comprises a first circuit RCB_D1 configured to control the slope of the first portion and a second circuit RCB_D2 to control the slope of the second portion. The two circuits are connected in parallel to the word line WL.

The first circuit RCB_D1 is similar to the world line driver of figure 7e. The first circuit controls the slow opening of the write transistor WT during the first portion of the trailing edge, by slowly discharging the word line WL through the main transistor MN2 connected to the ground, as this has been explained with reference to this figure 7e. The second circuit RCB_02 controls the further opening of the word line transistor WLT, by further discharging the world line WL. The second circuit comprises a switching transistor MP4, here a PMOS transistor, whose gate is connected to the word line WL and its source to a source voltage Vdd. When the word line WL falls under the switching transistor MP4 threshold, its drain rises to the source voltage Vdd, and activate the low resistive additional transistor MN4 such that the word line WL discharge more quickly. More particularly, the drain-source resistance of the additional transistor MN4 is selected such that word line potential is pull down rapidly.

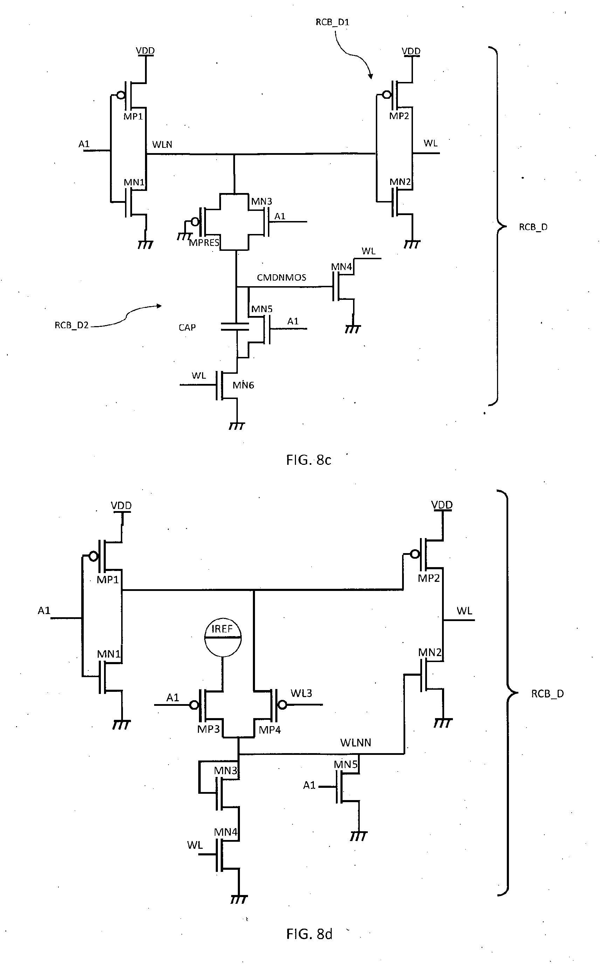

Figure 8c represents an alternative circuit to the one of figure 8b. Just like the circuit of figure 8b, the word line driver RCB_D of figure 8c comprises a first circuit RCB_D1 composed of the two main transistors MP2, MN2 in series between a source voltage VDD and the ground configured to control the slope of the first portion. The first circuit RCB_D1 controls the slow opening of the word line transistor WLT during the first portion of the trailing edge, by slowly discharging the word line WL through the main transistor MN2 connected to the ground, as this has been explained with reference to the figures 7e, 8b.

The circuit of figure 8c comprises a second circuit RCB_D2 to control the slope of the second portion. This is obtained by further discharging the word line after a given time through a relatively less resistive transistor MN4, when compared to the discharging main transistor MN2. In the second circuit, a delay is generated thanks to a capacitor CAP slowly charged across a resistive transistor MPRES. The capacitor CAP is connected to the gate of the relatively less resistive transistor, and when the charge of the capacitor exceeds the relatively less resistive transistor MN4 thresholds and activate it, the word line WL is rapidly discharged.

Figure 8d represents a further alternative circuit to the ones of figure 8b and 8c.

The word line driver RCB_D represented on figure 8d comprises a constant current source IREF, a first and a second main transistors MP2, MN2 connected in series in between a source voltage Vdd and a ground voltage. At the end of the write pulse A1 provided by the main control block 4, the second main transistor MN2 discharges the world line WL at constant current. This is due to the constant current source IREF connected to a diode connected MOS MN3 which polarizes the gate of the second main transistor MN2. Therefore, MN3 and the second main transistor MN2 is operated in a current mirror configuration to discharge the word line WL in a constant current condition and to control the slope of the first portion. A switching transistor MP4 connects the gate of the second main transistor MN2 to ground when the word line WL falls under the switching transistor MP4 threshold voltage to discharge quickly the word line WL during the second portion.

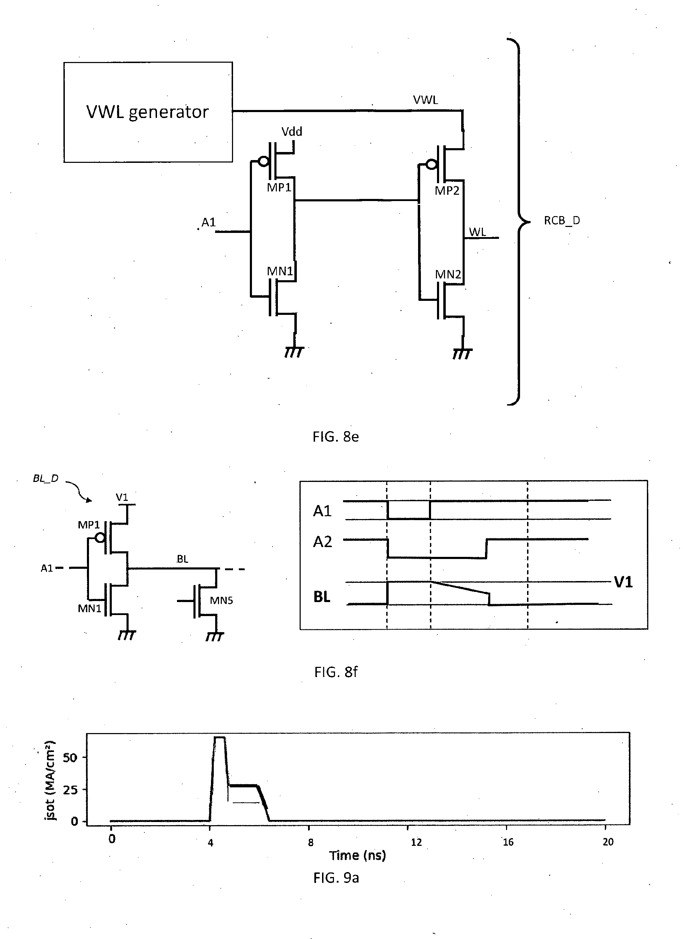

Figure 8e represents a further alternative circuit to the ones of figure 8b, 8c and 8d. In the circuit of figure 8e, the word line driver RCB_D comprises at least one voltage generator whose generated voltage may be programmed or controlled by the main control block 4. The word line driver RCB_D of figure 8e also comprises two main transistors MP2, MN2 connected in series in between the source voltage provided by the controlled voltage generator and a ground voltage. The word line WL is connected to a middle point of the two main transistors MP2, MN2. In this circuit, the generator generates a constant supply voltage VWL until the time the word line WL has to discharge slowly. Then, the generator reduces the provided voltage VWL slowly and, when the write pulse provided by the main control block 4 falls to 0, the word line WL is discharged rapidly through the second main transistor MN2 connected to the ground.

Figure 8f represents a bit line driver BL_D that is configured to produce the first pulse of figure 8a in a memory device operating according to the second mode of operation, where the bit line driver is operated after the word line driver closes the write transistor WT to create the write path. The word line driver may then be of conventional nature in this second mode of operation.

The bit line driver BL_D comprises two main transistors MP1, MN1 connected in series in between a source voltage V1 and a ground voltage, the bit line BL being connected to a middle point of the two main transistors MP1, MN1. The second main transistor MN1 connected to the ground voltage is a "resistive transistor. It has been dimensioned to slowly pull down the bit line, given the capacitance of the write path. A first bit line driver control signal A1 provided by the main control block 4 is applied to the gates of the two main transistor MP1, MN1, to either connect the bit line BL to the source voltage V1 or to the ground, and therefore shape the first current pulse during a first portion of the trailing edge.

The bit line driver further comprises at least one additional transistor MN5 connected between the middle point and the ground voltage. The additional transistor MN5 is a "big transistor", it has been dimensioned to rapidly pull down the bit line, given the capacitance of the write path. A second bit line driver control signal A2 provided by the main control block 4 is applied to the gate of the additional transistor MN5 to pulls down the bit line voltage rapidly the second portion of the trailing edge.

### Example 3

In this example 3, the trailing edge of the first current pulse comprises a plateau, -as shown in the figure 9a.

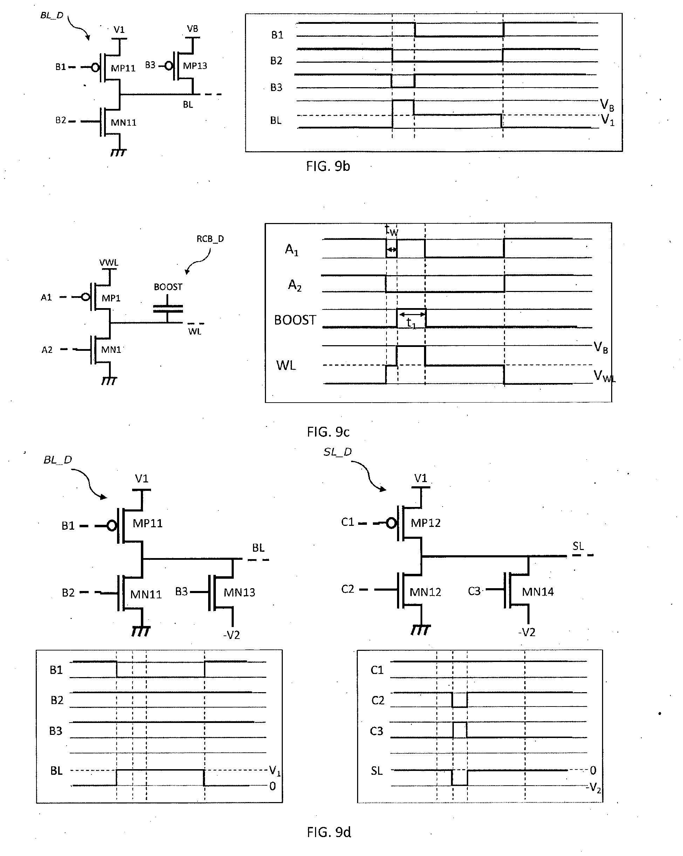

Figure 9b represents a bit line driver BL_D that is configured to produce the first pulse of figure 9a in a memory device operating according to the second mode of operation, where the bit line driver is operated after the word line driver closes the write transistor WT to create the write path. The word line driver may then be of conventional nature in this second mode of operation.

The bit line driver BL_D of figure 9b comprises two main transistors MP11, MN11 connected in series in between a first source voltage V1 and a ground voltage, the bit line being connected to a middle point of the two transistors. The bit line driver further comprises at least one additional transistor MP13 connected between the middle point and a second voltage source VB, greater from the first voltage source.

A first, second and third bit line driver control signals B1, B2, B3 provided by the main control block 4 are respectively applied to the gates of main and additional transistors. The additional transistor MP13 is activated during the hold time duration of the first current pulse to pull the bit line to the greater second source voltage. Then the bit line is pulled to the first voltage source, defining the plateau of the pulse, before the main transistor MN11 pulls downs the bit line voltage to ground.

Figure 9c represents another circuit for a word line driver RCB_D configured to produce the first pulse of figure 9a with a plateau. The word line driver of figure 9c comprises two main transistors MP1, MN1 connected in series in between a first word line source voltage VWL and a ground voltage, which in this alternative circuit may be conventional transistors. The word line is connected to a middle point of the two transistors. The word line driver further comprises a capacitance disposed between the word line and a controllable source of boost voltage BOOST.

In operation, the world line is initially pulled up to the first source voltage V1 by a first control signal A1. Consequently, the capacitance is charged to the source voltage V1, and the first control signal is disactivated after a first given period of time tw. Then, the voltage BOOST provided by the controllable source of boost voltage is increased during a second given period of time t1, increasing the voltage present on the word line. After this second period of time during which the pulse reaches its maximum value, the controllable source of boost voltage is controlled to provide the initial voltage and the first control signal A1 is activated to pull down the voltage on the word line back to the first source voltage V1. This is constituting the plateau of the write pulse. During this operation, the main transistor MN1 connected to the ground is kept open by.a second control signal A2. This control signal A2 activates this transistor MN1 to pull down the voltage of the word line and terminate the pulse.

Figure 9d represents a bit line driver BL_D and source line drivers SL_D that are configured to produce, in combination, the first pulse of figure 9a with a plateau, in a memory device operating according to the second mode of operation, where the bit line driver is operated after the word line driver closes the write transistor WT to create the write path. The word line driver may then be of conventional nature.

The bit line driver BL_D comprises two main transistors MP11, MN11 connected in series in between a source voltage V1 and a ground voltage. The two main transistors MP11, MN11 may be conventional. The bit line BL is connected to a middle point of the two main transistors MP1, MP2. The bit line driver further comprises at least one additional transistor MN13 connected between the middle point (the bit line) and a negative voltage -V2. The source line driver SL_D presents the same configuration with two main transistors MP12, MN12 connected in series and an additional transistor MN14 connected between the middle point (the source line) and a negative voltage -V2. In operation, to inject a first current pulse with a plateau in the bit line, the additional transistor MN14 of the source line driver is activated to negatively charge the source line during the period corresponding to the hold time duration of the first write pulse, while the bit line is charged positively. The operation of each transistor is operated by control signal B1, B2 and C3 provided in the right timings, as shown on the figure, by the control block 4 of the memory array.

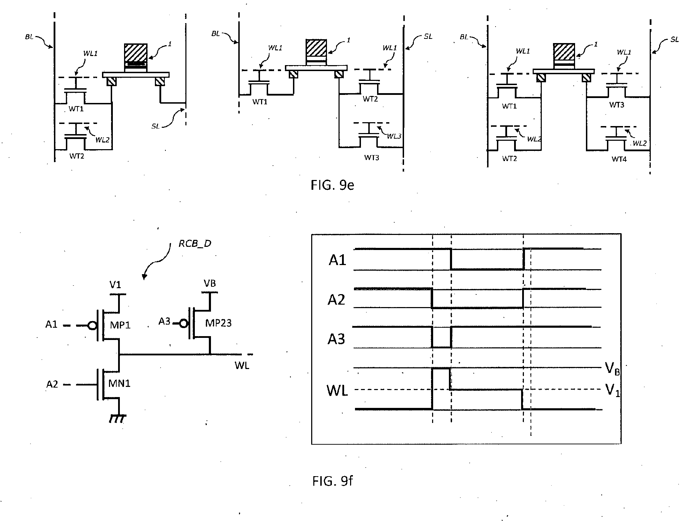

Figure 9e represents other configurations allowing to produce the first pulse of figure 9a with a plateau. In the configurations of this figure 9e, a single SOT memory cell 1 is provided with a plurality of word lines WL1,WL2 each provided with their respective word line drivers, to respectively control a plurality of write transistors WT1,WT2,WT3,WT disposed in the write path. At least two transistors are disposed in parallel of each other's. In these configurations the word line drivers, bit line drivers and source line drivers may be conventional.

In operation, the main control block 4 generates the control signals to word line drivers connected to the two transistors in parallel to close the two parallel sections of the write path, then open one of the two transistors to let just one section closed, and finally open both transistors to end the write pulse.

Figure 9f represents a word line driver RCB_D that is configured to produce the first, pulse of figure 9a, with a plateau in a memory device operating according to the second mode of operation, where the bit line driver is operated after the word line driver closes the write transistor WT to create the write path. The bit line and source line drivers may then be of conventional nature in this second mode of operation.

The word line driver RCB_D of figure'9f is similar to the bit line driver of figure 9b. The additional transistor MP23 is activated during the hold time duration of the first current pulse to pull the word line to the greater second source voltage VB. The circuit of figure 9f controls the opening of the write transistor WT to shape first current pulse with a plateau.

Other variations to the disclosed embodiments can be understood and effected by those skilled in the art in practicing the claimed invention, from a study of the drawings, the disclosure, and the appended claims.

## Claims

1. A magnetic memory device (100) comprising:
- at least one source line (SL) provided with a source line driver (SL_D) and at least one bit line (BL) provided with a bit line driver (BL_D) ;
- at least one SOT memory cell (1) comprising:
∘ a SOT current layer (3), defining a main plane, electrically disposed between the source line (SL) and the bit line (BL) to define a write path comprising the bit line (BL), the SOT current layer (3) and the source line (SL), and
∘ a free layer (2b) disposed on and coupled to the SOT current layer (3), a magnetization direction (M) of the free layer (2) being perpendicular to the main plane, and the magnetization orientation of the free layer (2b) defining a state of the memory cell (1);
- at least one word line (WL) provided with a word line driver (RCB_D), to control a write transistor (WT) disposed in the write path;
the bit line driver (BL_D), the source line driver (SL_D) and/or the word line driver (RCB_D) being configured to write a first state in the SOT memory cell (1) by injecting a first current pulse along a first direction of the write path, the first current pulse comprising a rising edge to elevate the current to a first maximum value and a trailing edge to reduce, from a trailing edge starting time, the current from the first maximum value, the magnetic memory device (100) being configured such that, 1 ns after the trailing edge starting time, the current of the first current pulse is greater than 30% of the first maximum value.

2. The magnetic memory device (100) of claim 1 wherein the current of the first current pulse, 1 ns after the trailing edge starting time, is greater than 60% of the first maximum value, preferentially greater than 80% of the first maximum value.

3. The magnetic memory device (100) of claim 1 or 2, also configured to write a second state in the SOT memory cell (1) by injecting the first current pulse along a second direction into the write path, the second direction being opposite to the first direction.

4. The magnetic memory device (100) of claim 1 or 2, also configured to write a second state in the SOT memory cell (1) by injecting a second current pulse along the first direction of the write path, the second current pulse comprising a rising edge to elevate the current to a second maximum value and a trailing edge to reduce, from the trailing edge starting time, the current from the second maximum value, such that, 1 ns after trailing edge starting time of the second current pulse, the current is less than 30% of the second maximum value.

5. The magnetic memory device (100) of claim 4, wherein the second maximum value is equal to the first maximum value.

6. The magnetic memory device (100) of claim 4 or 5, wherein the second maximum value is superior or equal to a critical current value for which the first state is stored in the SOT memory cell (1) with a write error rate equal to 1.

7. The magnetic memory device (100) according to any preceding claims wherein the memory cell (1) further comprises a thin dielectric layer (2a) sandwiched between the free layer (2b) and a ferromagnetic reference layer (2c) to form a magnetic tunnel junction structure (2).

8. The magnetic memory device (100) of claim 7 further ' comprising additional layers disposed on top of the ferromagnetic reference layer (2c).

9. The magnetic memory device (100) according to any preceding claims wherein the trailing edge of the first current pulse presents a substantially constant slope.

10. The magnetic memory device (100) according to any one of claims 1 to 8 wherein the trailing edge of the first current pulse comprises a first portion and a second portion following the first portion, the average slope of the first portion being smaller than the average slope of the second portion.

11. The magnetic memory device (100) according to claim 10 wherein the second portion decreases strictly monotonically.

12. The magnetic memory device (100) according to any one of claims 1 to 8 wherein the trailing edge comprises a plateau.

13. The magnetic memory device (100) according to claim 12, wherein the word line driver (RCB_D) comprises two main transistors (MP1, MN1) connected in series in between a first word line source voltage (VWL) a ground voltage, the word line being connected to a middle point of the two main transistors (MP1, MN1), and wherein the word line driver (RCB D) further comprises a capacitance disposed between the word line and a controllable source of boost voltage BOOST

14. The magnetic memory device (100) according to any preceding claims wherein the first maximum current value of the first current write pulse is maintained during a hold time duration comprised between 0 ns and 100 ns, and'preferably between 0 ns and 10 ns.

15. A method for writing a first state in at least one SOT memory cell (1) of a magnetic memory device (100), the magnetic memory device (100) comprising at least one source line (SL) provided with a source line driver (SL_D) and at least one bit line (BL) provided with a bit line driver (BL_D), the SOT memory cell (1) comprising:
∘ a SOT current layer (3), defining a main plane, electrically disposed between the source line (SL) and the bit line (BL) to define a write path comprising the bit line (BL), the SOT current layer (3) and the source line (SL), and
∘ a free layer (2b) disposed on and coupled to the SOT current layer (3), a magnetization direction (M) of the free layer (2b) being perpendicular to the main plane, and the magnetization orientation of the free layer (2b) defining a state of the memory cell (1);
and the magnetic memory device (100) further comprising at least one word line (WL) provided with a word line driver (RCB_D), to control a write transistor (WT) disposed in the write path, the method comprising injecting a first current pulse along a first direction of the write path, the first current pulse comprising a rising edge to elevate the current to a first maximum value and a trailing edge to reduce, from a trailing edge starting time, the current from the first maximum value, the method being **characterized in that** the first current pulse is prepared such that, 1 ns after the trailing edge starting time, the current of the first current pulse is greater than 30% of the first maximum value.

16. The method of claim 15 wherein injecting a first current pulse along a first direction of the write path comprises an opening step of opening the write transistor (WT) by applying a controlled voltage on a gate of the write transistor (WT) to control the trailing edge of the first current pulse.

17. The method of claim 15 wherein injecting a first current pulse along a first direction of the write path comprises a discharging step of discharging the bit line (BL) and/or the source line (SL), the discharging step being conducted to control the trailing edge of the first current pulse.

18. A current signal for writing a state in at least one SOT memory cell (1) of a magnetic memory device (100), the current signal comprising a' rising edge to elevate the current to a first maximum value and a trailing edge to reduce, from a trailing edge starting time, the current signal from the first maximum value, the current signal being **characterized in that**, 1 ns after the trailing edge starting time, the current is greater than 30% of the first maximum value.
